# EUROPÄISCHE PATENTSCHRIFT

(11) **EP 1 596 235 B1**
(45) Veröffentlichungstag und Bekanntmachung des Hinweises auf die Patenterteilung: **28.02.2007**
(21) Anmeldenummer: 05106797.3
(22) Anmeldetag: 19.01.1999
(51) Int. Cl.: G02B 7/00, G03F 7/20

(54) **Projektionsbelichtungsanlage der Mikrolithographie mit passiver thermischer Kompensation**
Optical device and a microlithography projection exposure system with passive thermal compensation
Dispositif optique et appareil d'exposition par projection pour microlithographie avec compensation thermique passive

(30) Priorität: 20.02.1998 DE 19807094
(43) Veröffentlichungstag der Anmeldung: 16.11.2005
(62) Teilanmeldung aus: 99100845.9
(73) Patentinhaber: Carl Zeiss SMT AG, 73447 Oberkochen (DE)
(72) Erfinder: Wagner, Christian Dr., 5521 KS, Eersel (NL); Trunz, Michael, 73479, Ellwangen (DE); Hilgers, Ralf, 22763, Hamburg (DE)
(74) Vertreter: Schultz, Jörg Martin

(56) Entgegenhaltungen:
- EP-A- 0 678 768
- US-A- 4 155 631
- PATENT ABSTRACTS OF JAPAN Bd. 011, Nr. 037 (P-543), 4. Februar 1987 (1987-02-04) -& JP 61 208002 A (TOSHIBA CORP), 16. September 1986 (1986-09-16)
- PATENT ABSTRACTS OF JAPAN Bd. 009, Nr. 031 (E-295), 9. Februar 1985 (1985-02-09) -& JP 59 175178 A (MITSUBISHI DENKI KK), 3. Oktober 1984 (1984-10-03)

## Beschreibung

Die Erfindung betrifft eine Projektionsbelichtungsanlage der Mikrolithographie nach dem Oberbegriff des Anspruchs 1, bei der eine nicht rotationssymmetrische thermische Beeinflussung eines optischen Elements durch die Lichtquelle erfolgt.

Diese Situation hat eine besondere Bedeutung bei Wafer-Scannern mit einem schlitzförmigen Bildfeld - entweder ein schmales Rechteck mit Verhältnis Breite zu Länge z.B. von typisch 1:5 bis zu 1:9, oder insbesondere bei Spiegelsystemen auch kreisbogenförmig.

Eine aktive Kompensation dadurch verursachter Abbildungsfehler ist aus EP-A 0 678 768 bekannt durch geregeltes oder gesteuertes nicht rotationssymmetrisches Heizen oder Kühlen oder andeutungsweise auch durch mechanisches Spannen.

Schon früher ist derartiges in der EP-B1 0 532 236 beschrieben, vorzugsweise als Heizung für Spiegel.

Aufgabe der Erfindung ist es, die durch Lichtabsorption und daraus folgende Erwärmung verursachte Veränderung der Eigenschaften optischer Elemente mit möglichst einfachen Mitteln deutlich zu reduzieren bzw. zu symmetrisieren.

Gelöst wird diese Aufgabe durch eine Projektionsbelichtungsanlage nach Anspruch 1.

Auf aktive, gesteuerte oder geregelte Eingriffe an den optischen Elementen wird verzichtet. Durch die Vermeidung aktiver Elemente und besonders einer Heizung wird der gesamte Energieeintrag in die Anordnung reduziert.

Andererseits geht die Erfindung mit der asymmetrischen Kühlung von bewährten, und besonders bei Projektionsbelichtungsanlagen bisher auf die Spitze getriebenen, Bauprinzipien der Fassungen mit hoher Symmetrie ab. Dieses Abgehen erfolgt z.B. in einer optischen Anordnung mit einer Lichtquelle und einem an einer Fassung befestigten optischen Element, wobei die Lichtquelle Strahlung emittiert und das optische Element damit derart beaufschlagt, dass eine Wärmezufuhr erfolgt, die keine der Form des optischen Elements entsprechende Symmetrie aufweist. Dabei ist zwischen optischem Element und Fassung eine Verbindungsstruktur vorgesehen, die eine nicht der Form des optischen Elements entsprechende Symmetrie aufweist und eine zumindest teilweise Homogenisierung der Temperaturverteilung im optischen Element bewirkt.

Alternativ oder zusätzlich kann auch eine optische Anordnung mit einer Lichtquelle und einem optischen Element das in einer Fassung befestigt ist verwendet werden, wobei die Lichtquelle Strahlung emittiert und das optische Element damit derart beaufschlagt, dass eine Wärmezufuhr erfolgt, die keine der Form des optischen Elements entsprechende Symmetrie aufweist. Dabei ist ein ein- oder mehrteiliges wärmeleitendes Element in Wirkverbindung mit dem optischen Element und der Fassung angeordnet, so dass eine Form des Wärmetransports erfolgt, die eine zumindest teilweise Kompensation der Asymmetrie der Temperaturverteilung im optischen Element bewirkt.

Bei der letzt genannten Ausführung oder bei einer Projektionsbelichtungsanlage der Mikrolithographie ist eine Kühlung durch Teile ohne Fassungsfunktion vorgesehen, so dass die eigentliche Fassung wieder symmetrisch bleiben kann. Dabei umfasst die Projektionsbelichtungsanlage ein optisches Element, das durch Strahlung nicht rotationssymmetrisch beheizt wird, und wobei mindestens ein Teil in thermischem Kontakt zum optischen Element steht und einen Teil des nicht von der Strahlung berührten Querschnitts des optischen Elements abdeckt, um Temperaturgradienten im optischen Element zu reduzieren.

Vorteilhafte Weiterbildungen der Erfindung sind Gegenstand der Unteransprüche 2 bis 11.

Näher erläutert wird die Erfindung anhand der Zeichnungen.
- Figur 1: zeigt schematisch eine Linse mit schlitzförmiger Ausleuchtung und Laschenverbindungen der Fassung aus verschiedenen Materialien;
- Figur 2: zeigt schematisch eine Linse mit dipolartiger Ausleuchtung und Verbindungen zur Fassung mit unterschiedlichen Querschnitten;
- Figur 3a: zeigt schematisch eine Linse mit schlitzförmiger Ausleuchtung in symmetrischer Fassung mit einem Kühlkörper von nicht rotationssymmetrischer Form;
- Figur 3b: zeigt einen Schnitt A-A von Figur 3a;
- Figur 3c: zeigt einen Schnitt B-B von Figur 3b;
- Figur 4: zeigt schematisch im Querschnitt eine Variante mit Kühllasche und Wärmeleitkabel;
- Figur 5a: gleichen zeigt ein FEM-Modell mit symmetrisch angeordneten Kühlkörpern;
- Figur 5b: zeigt dazu schematisch einen Querschnitt;
- Figur 6: zeigt ein gleichartiges FEM-Modell wie Figur 5a, bei dem die Kühlkörper nach Lage, Größe und Material variiert sind;
- Figur 7: zeigt eine Variante mit einem Kühlkörper mit temperaturinduzierter Veränderung der Kühlwirkung;
- Figur 8: zeigt im schematischen Schnitt einen Spiegel mit durch Stege aus verschiedenen Materialien bewirkter unterschiedlicher Kühlung; und
- Figur 9: zeigt schematisch die Übersicht einer Projektionsbelichtungsanlage.

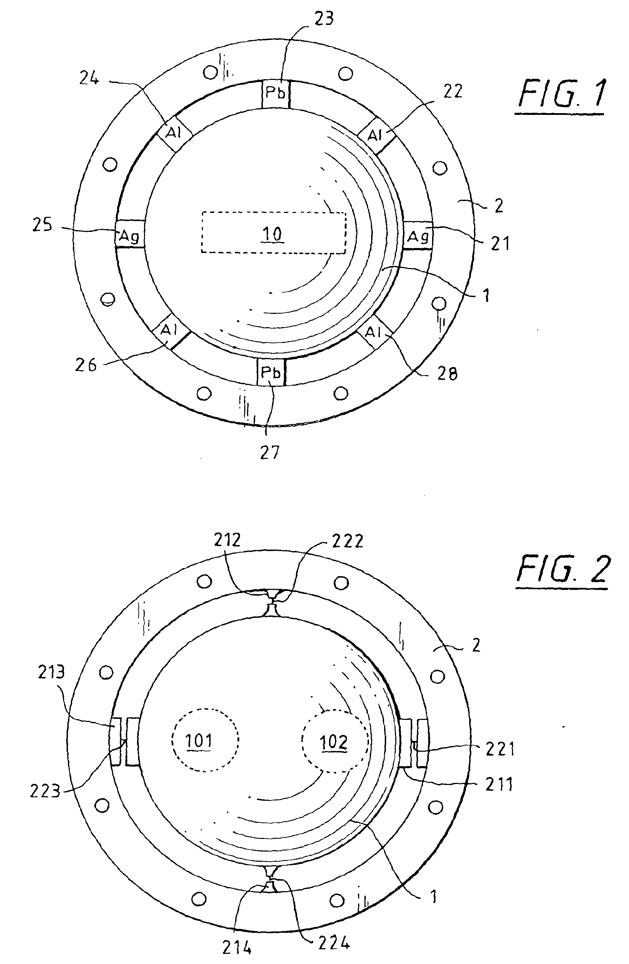

Die Anordnung der Figur 1 zeigt eine Linsenfassung 2, in der eine Linse 1 durch eine Vielzahl von Stegen 21-28 (gezeigt sind acht) weitestgehend spannungsfrei und exakt lagefixiert gehalten ist. Die Stege 21-28 (Speichen, Laschen) sind mit dem Rand der Linse 1 verklebt oder durch andere Fügeverfahren verbunden.

In einem schlitzförmigen Querschnitt 10 wird die Linse 1 ausgeleuchtet. Gerade bei Projektionsbelichtungsanlagen, die im UV- und DUV-Bereich arbeiten, ist das Problem, daß die Linsenwerkstoffe erhebliche Absorption aufweisen und in Folge also im Querschnitt 10 eine erhebliche Wärmezufuhr erfolgt. Die damit verbundene Temperaturerhöhung bewirkt eine Änderung des Brechungsindex und durch die Wärmeausdehnung zusätzlich eine Deformation. Insgesamt ergibt sich eine Veränderung der Linsenwirkung mit astigmatischer Wirkung.

Die Kühlung erfolgt nur zu einem geringen Teil über das Umgebungsgas (bei Projektionsbelichtungsanlagen in der Regel Helium) und durch Wärmestrahlung. Primär wird die Wärme über den Linsenkörper 1, die Fügestelle (Klebung) und das Gas in der Umgebung der Fügestelle und die Stege 21-28 auf die Fassung 2 abgeführt.

Erfindungsgemäß sind nun die Stege 21-28 in diesem Beispiel aus verschiedenen Materialien ausgeführt, womit sie unterschiedliche Wärmeleitfähigkeit aufweisen. Beispielsweise sind die dem schlitzförmigen Querschnitt 10 nächstgelegenen Stege 21, 25 aus Silber mit sehr guter Wärmeleitfähigkeit, die entferntesten 23, 27 aus Blei mit geringer Wärmeleitfähigkeit und die dazwischenliegenden Stege 22, 24, 26, 28 aus Aluminium mit mittlerer Wärmeleitfähigkeit. Die Temperaturverteilung in der Linse 1 wird also zwischen den Stegen 21, 23 relativ abgesenkt und zwischen den Stegen 23, 27 relativ angehoben, wodurch sich eine - zumindest teilweise - Homogenisierung und Symmetrisierung der Temperaturverteilung und eine reduzierte Störung der optischen Eigenschaften der Linse 1 ergibt.

In der Praxis sind auch weitere Eigenschaften der für die Stege 21-28 verwendeten Materialien, wie ihre Festigkeit, Elastizität, Wärmeausdehnung zu berücksichtigen. Simulationsrechnungen für die mechanischen, thermischen und optischen Eigenschaften unter Nutzung der Finite Elemente Methode ermöglichen hier eine optimierte Auswahl und Ausführung der Anordnung.

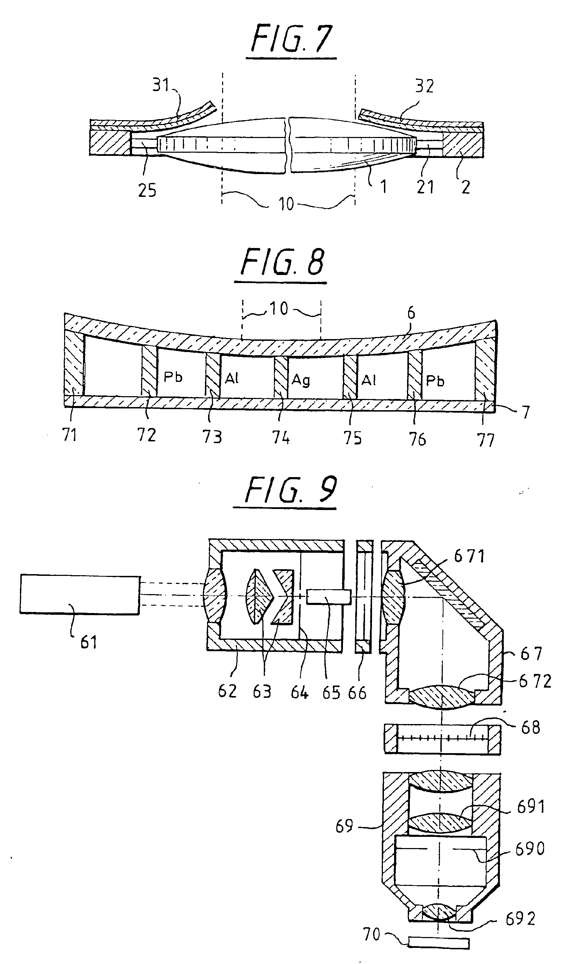

Eine Alternative, die an sich nicht zur Erfindung gehört aber zur Kombination mit oben genanntem Beispiel eignet, gibt Figur 2 wieder. Hier sind Linse 1 und Fassung 2 über Stege 211 bis 214 (vier Stück nur zur klaren Darstellung, in der Praxis mehr) mit unterschiedlichem Querschnitt und dadurch unterschiedlicher Wärmeleitung verbunden. Unterschiedliche mechanische Eigenschaften sind dadurch unterbunden, daß jeder Steg 211 bis 214 gleichartige Federgelenke 221 bis 224 aufweist. Die Wärmeleitung über die danebenliegenden schmalen Spalte (es werden nur minimale Beweglichkeiten der Gelenke benötigt) erfolgt hinreichend wirksam durch das Füllgas (Helium) oder durch ein parallel geschaltetes flexibles Metallkabel (Litze) (vgl. Fig. 6b).

Auch hier wird die genaue Kombination mit Unterstützung von Simulationsrechnungen festgelegt. Die Kombination mit der Verwendung unterschiedlicher Werkstoffe, wie in Figur 1 dargestellt, eröffnet erweiterte Anpassungsmöglichkeiten.

Weiter ist in dieser Figur 2 eine "Dipol"-Ausleuchtung der Linse mit zwei außermittigen Lichtflecken 101, 102 dargestellt, wie sie im Bereich der Blendenebene und äquivalenter Ebenen von Projektionsbelichtungssystemen mit symmetrischer schiefer Beleuchtung vorkommt. Auch damit ergeben sich astigmatische Fehler durch die Lichtabsorption, die durch die passivkompensierende Kühlung vermindert werden können.

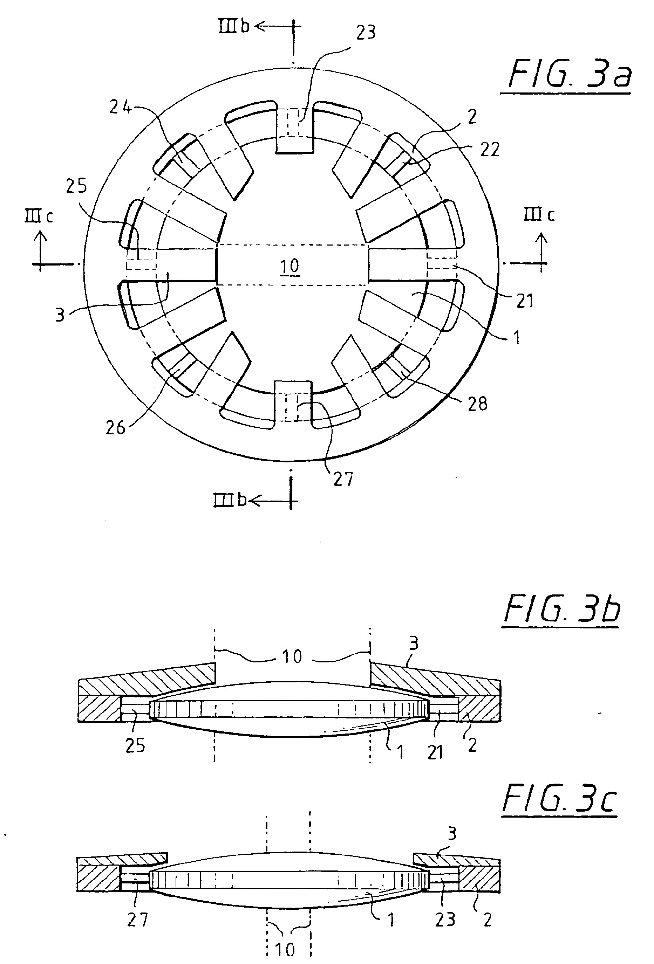

Figur 3a-c zeigt eine Variante der Erfindung mit einem zusätzlichen, nur für die ausgleichende Kühlung vorgesehenen, wärmeleitenden Element 3.

Linse 1 und Fassung 2 sind dabei beispielsweise mit gleichmäßigen Stegen oder mit selektiv kühlenden Stegen 21-28 nach Figur 1 oder 2 verbunden. Jede andere Fassungstechnik ist gleichermaßen.anwendbar.

Das wärmeleitende Element 3 ist mit der Fassung 2 gut wärmeleitend fest verbunden und überdeckt Teile der Linse 1, welche nicht vom Licht durchdrungen werden, also außerhalb der auch hier als Schlitz dargestellten ausgeleuchteten Fläche 10.

Diese Überdeckung erfolgt vorzugsweise berührungsfrei, etwa mit einem Abstand von rund 0,1 mm, so daß unter Vermittlung des Füllgases eine gute Wärmeübertragung gewährleistet ist, zugleich aber keine Spannungen in die Linse 1 eingetragen werden können. Bessere Wärmeleitung ergibt sich natürlich, wenn der Spalt zwischen Linse 1 und wärmeleitendem Element 3 mit Kleber, einem Gel, Flüssigkristallen oder ähnlichem, möglichst wenig Spannung übertragendem Material, ausgefüllt wird.

Die Wärmeleitung und deren lokale Verteilung wird durch die Form des wärmeleitenden Teils 3 eingestellt - Figur 3b zeigt, wie das Teil 3 bis nahe an den ausgeleuchteten Bereich 10 in der Richtung A-A der Länge des Schlitzes reicht, und Figur 3c zeigt, daß in der Querrichtung B-B der Abstand groß gehalten ist.

Mit der in Figur 3a gezeigten Ausführung des wärmeleitenden Elements 3 mit einer Mehrzahl von Fingern oder Speichen kann auch deren Breite, Form und Verteilung zur Einstellung der Wärmeleitung herangezogen werden. Auch bei Ausführung als durchgehende Scheibe bzw. Lochblende kann die Dicke des wärmeleitenden Elements örtlich verschieden ausgeführt werden. Auch ist es möglich, die einzelnen Finger analog zu den Stegen 21-28 nach Figur 1 aus verschieden wärmeleitenden Materialien zu machen. Natürlich kann das wärmeleitende Element 3 auch beidseitig an der Linse 1 angeordnet werden.

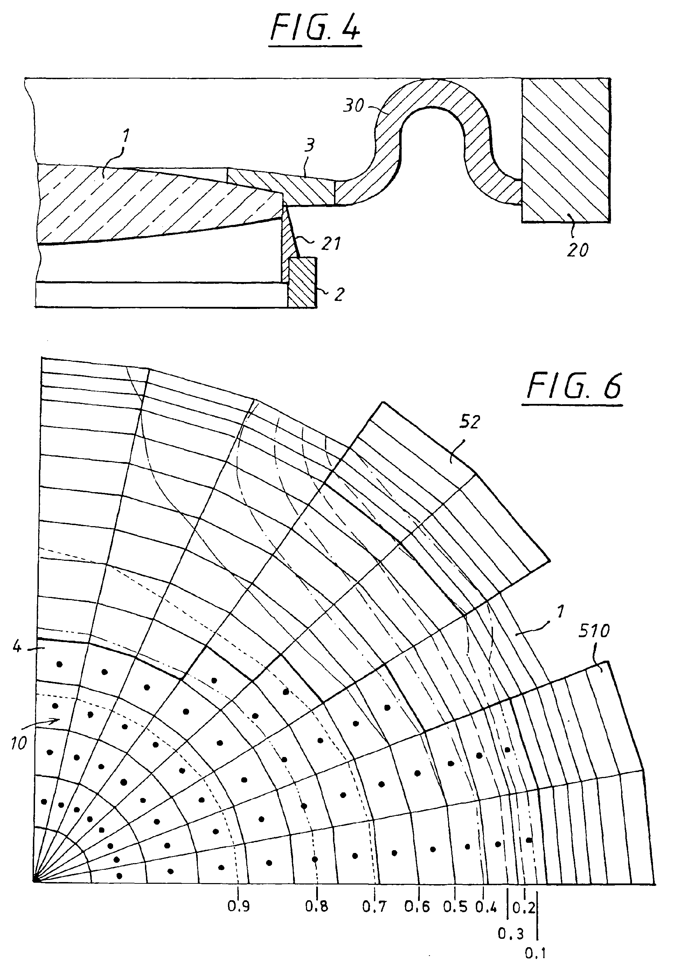

Fig. 4 zeigt in einer Fig. 3b entsprechenden Darstellung eine Möglichkeit, wie das Kühlelement 3 in stoff- oder formschlüssigen Kontakt zur Linse 1 gebracht werden kann, ohne daß die mechanischen Eigenschaften der Fassung 2 und der Verbindungsteile 21 gestört werden. Das Kühlelement 3 wird dazu mit einem flexiblen wärmeleitenden Kabel 30 ausgestattet - z.B. einer Kupferlitze - und an eine Wärmesenke 20 angeschlossen.

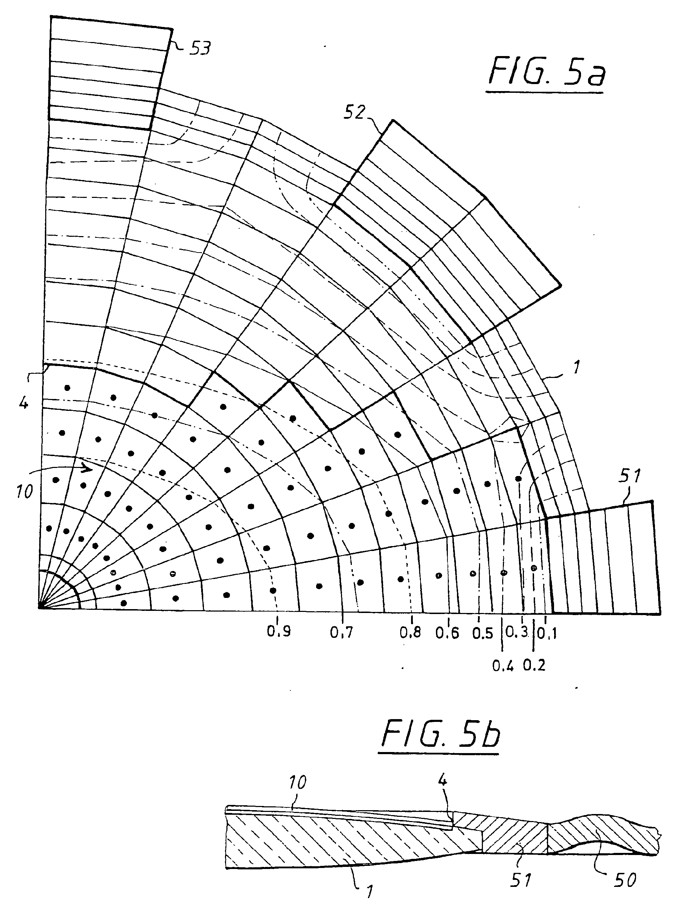

Figur 5a zeigt in Aufsicht das Finite-Elemente-Modell eines Quadranten einer Linse 1 aus Quarzglas (Mittendicke 14,4 mm, oberer Krümmungsradius 1600 mm, unterer Krümmungsradius 220 mm - bikonvex -, Durchmesser 160 mm). Acht massive Laschen (51, 52, 53) aus Aluminium sind gleichmäßig verteilt in der aus dem Schnitt Figur 5b erkennbaren Weise an der Linse 1 angeordnet. Sie sind 30 mm breit, über der Linse 2 mm dick und radial 6 mm überdeckend, außerhalb sind sie nochmals radial 8 mm lang in 4 mm Dicke. Am Außenrand sind sie auf Basistemperatur gehalten, z.B. durch flexible wärmeleitende Litzen 50.

Auf der gezeigten Oberfläche der Linse 1 wird in dem Bereich 4, der etwa ein Rechteck annähert in der gewählten Elementaufteilung, wird eine Wärmeeintragung durch Lichtabsorption von 1 W/cm² angesetzt. Die Temperaturerhöhung im Mittelpunkt erreicht dann 7,6 Milligrad. Eingezeichnet sind die Isothermen 0,1 bis 0,9, welche den Verlauf der Linien mit dem entsprechenden Bruchteil dieser Temperaturerhöhung anzeigen. Bei höherem Wärmeeintrag skaliert die Temperaturerhöhung in weiten Bereichen linear.

Ganz offensichtlich ist bei dieser dem Stand der Technik zuzurechnenden Ausführung mit symmetrischer Kühlanordnung die erreichte Temperaturverteilung stark unsymmetrisch über die ganze Linse verteilt.

Bei der erfindungsgemäßen Ausführung, die in Figur 6 dargestellt ist, sind die auf der Y-Achse liegenden Kühllaschen entfallen. Die auf der X-Achse liegenden Kühllaschen 510 sind in der Breite verdoppelt und zusätzlich aus dem besser wärmeleitenden Silber gefertigt. Die Laschen 52 dazwischen bleiben unverändert, ebenso wie die Wärmezufuhr im Bereich 4.

Damit wird nun die Temperaturerhöhung am Mittelpunkt 9,2 Milligrad. Die Isothermen sind bis etwa zum 0,7-fachen der maximalen Temperaturerhöhung und zum halben Linsendurchmesser jetzt gut rotationssymmetrisch.

Die mechanische Fassung der Linse 1 kann entweder durch die Kühllaschen 510, 52 erfolgen, oder es ist eine beliebige Fassungstechnik vorgesehen, die vorzugsweise vergleichsweise geringe Wärmeleitung aufweist.

Figur 7 zeigt eine Variante ähnlich Figur 3a-c, bei der die Finger 31, 32 des wärmeleitenden Elements aus Bimetall - zwei Lagen Material mit verschiedener Wärmeausdehnung - ausgeführt sind. Links im Bild ist bei der niedrigen Temperatur t₁ der Bimetallstreifen 31 von der Linse 1 weggebogen, er kann nur wenig Wärme aufnehmen. Rechts im Bild bei der höheren Temperatur t₂ ist der Bimetallstreifen 32 gestreckt und liegt in geringem Abstand zur Linse 1, so daß er viel Wärme abführen kann.

Außer bei den in den vorangegangenen Beispielen gezeigten Linsen kann die Erfindung natürlich auch bei prismatischen Teilen, bei Gittern oder Spiegeln angewendet werden, eben allen ungleichmäßig wärmebelasteten optischen Bauteilen.

Figur 8 zeigt eine speziell auf einen Spiegel 6 adaptierte Ausführung. Der Spiegel 6 ist auf einer Halterung 7 über auf seiner Rückseite verteilte Stützen 71 bis 77 - einzelne Stege oder Stützringe - abgestützt.

Über ihre Verteilung auf der Rückseite des Spiegels 6, ihre Form sowie über die spezifische Wärmeleitfähigkeit ihres Materials (z.B. in der Mitte 74 aus Silber, am Rand 72, 76 aus Blei, sonst (73, 75) Aluminium und der Außenrand 71, 77 aus Zerodur) wird die Kühlwirkung nach Bedarf eingestellt, in Anpassung an die ausgeleuchtete Fläche 10.

Die unterschiedliche Wärmeausdehnung der Materialien für die Stützen 71-77 kann ebenfalls gezielt ausgenutzt werden, um Deformationen.des Spiegels 6 aufgrund der Erwärmung zu kompensieren, oder aber auch gezielt herbeizuführen. Im letzteren Fall können dann Störungen anderer optischer Elemente, die in einem System mit dem Spiegel 6 zusammenwirken, kompensiert werden.

Figur 9 zeigt das komplette optische System einer Projektionsbelichtungsanlage der Mikrolithographie im schematisierten Überblick. Ein DUV-Excimer-Laser dient als Lichtquelle 61. Eine strahlformende Optik 62 mit Zoom-Axicon-Objektiv 63, wahlweise einer Blende 64 (wechselbar, konventionelle, Ringapertur, Dipol-, Quadrupol-Apertur) und einem homogenisierenden Quarzstab 65 leuchtet die REMA-Blende 66 homogen aus, die durch das folgende REMA-Objektiv 67 als scharf berandeter homogener Leuchtfleck, insbesondere als schmaler Scan-Schlitz, auf die Maske 68 abgebildet wird.

Das folgende verkleinernde Projektionsobjektiv 69 bildet die Maske 68 auf dem Wafer 70 ab. Die feldnahen Linsen 671 und 672 des REMA-Objektivs 67 und 692 des Projektionsobjektivs 69 sind nun bevorzugte optische Elemente, an denen die erfindungsgemäße Kühlung eingesetzt wird. Diese Kühlung reduziert die bei einem Scanner, bei dem Maske 68 und Wafer 70 synchron gescannt werden, aufgrund des schmalen schlitzförmigen ausgeleuchteten Feldes entstehenden Abbildungsfehler.

Die Linse 691 ist nächst der Aperturblende 690 des Projektionsobjektivs 69 angeordnet. Sie wird durch besondere Beleuchtungsarten, z.B. Dipol-Apertur, besonders belastet (vgl. Figur 2). Durch die erfindungsgemäße asymmetrische Kühlung kann jedoch auch diese Störung reduziert werden.

Es ist klar, daß die Beschreibung der Figuren nur Beispiele für die in den Ansprüchen definierte Erfindung wiedergibt. Insbesondere sind vielfältige Kombinationen der beschriebenen Merkmale erfindungsgemäß möglich und die Kühlung kann auch verstellbar ausgeführt werden, um zu justieren, an Veränderungen.anzupassen usw..

## Patentansprüche

1. Projektionsbelichtungsanlage der Mikrolithographie mit einer Lichtquelle und einem optischen Element (1), das durch Strahlung der Lichtquelle nicht rotationssymmetrisch beheizt wird, und einer nicht rotationssymmetrischen Kühlung (21-28, 211-214, 3) des optischen Elements (1), wobei die Kühlung durch passive wärmeleitende Einrichtungen (21-28, 211-214, 3) bewirkt wird, **dadurch gekennzeichnet, dass** die passiven wärmeleitenden Einrichtungen (211-214, 3) aus Stegen (21-28) aus verschiedenen Materialien bestehen, so dass eine zumindest teilweise Homogenisierung der Temperaturverteilung im optischen Element bewirkt wird.

2. Projektionsbelichtungsanlage der Mikrolithographie nach Anspruch 1, **dadurch gekennzeichnet, dass** die Stege (21-28, 211-214) mit unterschiedlichem Querschnitt versehen sind.

3. Projektionsbelichtungsanlage der Mikrolithographie nach Anspruch 1 oder 2, **dadurch gekennzeichnet, dass** die Stege (21-28, 211-214) gleichartige Federgelenke (221-224) aufweisen.

4. Projektionsbelichtungsanlage der Mikrolithographie nach einem der Ansprüche 1 bis 3, **dadurch gekennzeichnet, dass** die passiven wärmeleitenden Einrichtungen (211-214, 3) Finger aus unterschiedlichem Material, unterschiedlicher Breite, Form oder Dicke aufweisen.

5. Projektionsbelichtungsanlage der Mikrolithographie nach einem der Ansprüche 1 bis 4, **dadurch gekennzeichnet, dass** mindestens ein Teil (3) in thermischem Kontakt zum optischen Element (1) steht, einen Teil des nicht von der Strahlung berührten Querschnitts des optischen Elements (1) abdeckt, und Temperaturgradienten im optischen Element (1) reduziert.

6. Projektionsbelichtungsanlage der Mikrolithographie nach einem der Ansprüche 1 bis 5, **dadurch gekennzeichnet, dass** das optische Element (1) ein Spiegel (6) oder ein transmittierendes Element, insbesondere eine Linse (1) ist.

7. Projektionsbelichtungsanlage der Mikrolithographie nach einem der Ansprüche 1 bis 6, **dadurch gekennzeichnet, dass** das Bildfeld (10) schlitzförmig ist.

8. Projektionsbelichtungsanlage der Mikrolithographie nach einem der Ansprüche 1 bis 7, **dadurch gekennzeichnet, dass** das optische Element (671, 672, 692) nahe einer Feldebene oder nahe einer Pupillenebene (690) angeordnet ist.

9. Projektionsbelichtungsanlage der Mikrolithographie nach Anspruch 5, **dadurch gekennzeichnet, dass** das oder die in thermischem Kontakt stehenden Teile (3, 31, 32) aus mehreren verschiedenen Materialien bestehen.

10. Projektionsbelichtungsanlage nach Anspruch 5, **dadurch gekennzeichnet, dass** das oder die in thermischem Kontakt stehenden Teile (31, 32) zumindest teilweise verstellbar sind.

## Claims

1. Microlithographic projection exposure apparatus, having a light source and an optical element (1) which is heated non-axisymmetrically by radiation from the light source, and non-axisymmetric cooling (21-28, 211-214, 3) of the optical element (1), the cooling being carried out by passive thermally conductive devices (21-28, 211-214, 3), **characterized in that** the passive thermally conductive devices (211-214, 3) consist of struts (21-28) of different materials so as to bring about at least partial homogenization of the temperature distribution in the optical element.

2. Microlithographic projection exposure apparatus according to Claim 1, **characterized in that** the struts (21-28, 211-214) are provided with different cross sections.

3. Microlithographic projection exposure apparatus according to Claim 1 or 2, **characterized in that** the struts (21-28, 211-214) comprise resilient articulations (221-224) of the same type.

4. Microlithographic projection exposure apparatus according to one of Claims 1 to 3, **characterized in that** the passive thermally conductive devices (211-214, 3) comprise fingers of different material, different width, shape or thickness.

5. Microlithographic projection exposure apparatus according to one of Claims 1 to 4, **characterized in that** at least one part (3) is in thermal contact with the optical element (1), covers a part of that cross section of the optical element (1) which is not touched by the radiation, and reduces temperature gradients in the optical element (1).

6. Microlithographic projection exposure apparatus according to one of Claims 1 to 5, **characterized in that** the optical element (1) is a mirror (6) or a transmissive element, in particular a lens (1).

7. Microlithographic projection exposure apparatus according to one of Claims 1 to 6, **characterized in that** the image field (10) is slit-shaped.

8. Microlithographic projection exposure apparatus according to one of Claims 1 to 7, **characterized in that** the optical element (671, 672, 692) is arranged near a field plane or near a pupil plane (690).

9. Microlithographic projection exposure apparatus according to Claim 5, **characterized in that** the part or parts (3, 31, 32) which are in thermal contact consist of a plurality of different materials.

10. Projection exposure apparatus according to Claim 5, **characterized in that** the part or parts (31, 32) which are in thermal contact are at least partially adjustable.

## Revendications

1. Dispositif optique et appareil d'exposition par projection pour microlithographie avec une source lumineuse et un élément optique (1), qui est chauffé de manière non symétrique en rotation par le rayonnement de la source lumineuse, et un refroidissement non symétrique en rotation (21-28, 211-214, 3) de l'élément optique (1), le refroidissement étant réalisé par des dispositifs thermoconducteurs passifs (21-28, 211-214, 3), **caractérisé en ce que** les dispositifs thermoconducteurs passifs (211-214, 3) sont réalisés au moyen de barrettes (21-28) en différentes matières, de sorte à induire une homogénéisation au moins partielle de la distribution de la température dans l'élément optique.

2. Dispositif optique et appareil d'exposition par projection pour microlithographie selon la revendication 1, **caractérisé en ce que** les barrettes (21-28, 211-214) ont des sections différentes.

3. Dispositif optique et appareil d'exposition par projection pour microlithographie selon la revendication 1 ou 2, **caractérisé en ce que** les barrettes (21-28, 211-214) sont munies d'articulations à ressort (221-214) de même type.

4. Dispositif optique et appareil d'exposition par projection pour microlithographie selon l'une des revendications 1 à 3, **caractérisé en ce que** les dispositifs thermoconducteurs passifs (211-214, 3) sont munis de doigts réalisés dans des matières différentes, avec des largeurs, des formes ou des épaisseurs différentes.

5. Dispositif optique et appareil d'exposition par projection pour microlithographie selon l'une des revendications 1 à 4, **caractérisé en ce qu'**au moins une pièce (3) est en contact thermique avec l'élément optique (1), recouvrant une partie de la section de l'élément optique (1) qui n'est pas touchée par le rayonnement et réduisant les gradients de température dans l'élément optique (1).

6. Dispositif optique et appareil d'exposition par projection pour microlithographie selon l'une des revendications 1 à 5, **caractérisé en ce que** l'élément optique (1) est un miroir (6) ou un élément de transmission, notamment une lentille (1).

7. Dispositif optique et appareil d'exposition par projection pour microlithographie selon l'une des revendications 1 à 6, **caractérisé en ce que** le champ d'image (10) a une forme de fente.

8. Dispositif optique et appareil d'exposition par projection pour microlithographie selon l'une des revendications 1 à 7, **caractérisé en ce que** l'élément optique (671, 672, 692) est disposé à proximité d'un plan d'une ouverture ou à proximité d'un plan de pupille (690).

9. Dispositif optique et appareil d'exposition par projection pour microlithographie selon la revendication 5, **caractérisé en ce que** la ou les pièces qui sont en contact thermique (3, 31, 32) sont réalisées en plusieurs matières différentes.

10. Dispositif optique et appareil d'exposition par projection pour microlithographie selon la revendication 5, **caractérisé en ce que** les pièces qui sont en contact thermique (31, 32) sont au moins partiellement réglables.
